# EUROPEAN PATENT APPLICATION

(11) **EP 1 229 769 A1**
(43) Date of publication of application: **07.08.2002**
(21) Application number: 01945697.9
(22) Date of filing: 29.06.2001
(51) Int. Cl.: H05K 1/09, H05K 3/20, H05K 3/22, H05K 3/38, B32B 15/08

(54) **CARRIER-FOILED COPPER FOIL CIRCUIT, PRINTED CIRCUIT BOARD MANUFACTURING METHOD USING THE CIRCUIT, AND PRINTED CIRCUIT BOARD**

(30) Priority: 07.07.2000 JP 2000207112
(71) Applicant: Mitsui Mining & Smelting Co., Ltd., Tokyo 141-8584 (JP)
(72) Inventor: HIRASAWA, Yutaka, c/o MITSUI MINING & SMELTING, Ageo-shi, Saitama 362-0013 (JP); YAMAMOTO, Takuya, c/o MITSUI MINING & SMELTING, Ageo-shi, Saitama 362-0013 (JP); TAKAHASHI, Naotomi, c/o MITSUI MINING & SMELTING, Ageo-shi, Saitama 362-0013 (JP)
(74) Representative: Allard, Susan Joyce
(86) International application number: JP0105615
(87) International publication number: WO0205605

(57) **Abstract**

The invention provides a printed wiring board manufacturing material and a method of manufacturing the printed wiring board, capable of greatly reducing the cost for manufacturing the printed wiring board, thereby supplying the printed wiring board at a reduced cost. In order to achieve the above object, there is provided a printed wiring board manufacturing method which is characterized by the steps of: using copper foil circuit with a carriers each having an organic release layer interposed between a carrier and a copper foil circuit layer; using the copper foil circuit with a carrier and at least one prepreg each forming a resin base material, carrying out a hot pressing under a condition in which each surface with a copper foil circuit formed thereon has been brought into contact with the at least one prepreg, thereby producing a copper clad laminate; and peeling off and thus removing the carrier from the outer surface of the outer layer of the copper clad laminate.

## Description

### TECHNICAL FIELD TO WHICH THE INVENTION BELONGS

The present invention relates to a copper foil circuit with a carrier formed by supporting a copper foil circuit on a carrier, also relates to a method for manufacturing a printed wiring board using the copper foil circuit with a carrier. This invention further relates to an improved printed wiring board.

### BACKGROUND TECHNOLOGY

In a conventional process for manufacturing a copper clad laminate, a copper foil manufactured by a copper foil maker is supplied to a copper clad laminate maker so that the copper foil is bonded to a substrate material in order to be processed into a copper clad laminate. The copper clad laminate is then supplied to a printed circuiut board (PCB) shop in which a printed wiring circuit is formed on the surface of the copper clad laminate.

A process for manufacturing the printed wiring board in the PCB shop may be described briefly in the following. That is, in the case of a copper clad laminate formed by spreading a conventional copper foil on to a substrate material, the surface of the copper clad laminate is subjected to a surface treatment such as physical polishing treatment using a buff, and a chemical polishing treatment. After the surface treatment, an etching resist layer is formed on the surface of the copper clad laminate, followed by an exposing treatment so as to develop a copper foil circuit pattern, thereby accomplishing a registration process. Subsequent steps include a copper etching treatment and an etching resist layer removal treatment, thereby producing the printed wiring board. Namely, at least 4 to 5 steps are needed to produce the printed wiring board.

On the other hand, in the case where a copper clad laminate is manufactured by using a copper foil with a carrier rather than using a conventional copper foil, a difference between this case and the above-described case is that its carrier removal step is carried out as a first step. The process from the surface treatment to the final formation of a printed wiring board is just the same as the case in which a conventional copper foil is used to manufacture a copper clad laminate.

Recently, there has been an increasingly strong demand for reducing the cost of manufacturing electronic and electric products containing printed wiring board, requiring that these products should be supplied to users at low prices but ensuring high quality. For this reason, even the industrial circle of manufacturing printed wiring board has been required to manufacture, at a further reduced cost, printed wiring board serving as electronic parts.

However, as long as the above-described conventional process for manufacturing printed wiring board remains unchanged, it is difficult to shorten production line and there is a limit which makes it impossible to further reduce the cost of manufacturing the printed wiring board.

In view of the above, makers of manufacturing printed wiring board have begun to consider using materials having a reduced price and a lower quality. As a result, it is impossible to achieve an original object of supplying high quality product at a low price.

For this reason, a method capable of manufacturing printed wiring board at a reduced cost has been in discussion and consideration from various different points of view. However, there is still not existing an improved method which does not require reforming the existing equipment and which can be used in all the present maker's factories, capable of manufacturing printed wiring board at a reduced cost.

### BRIEF DESCRIPTION OF THE DRAWINGS

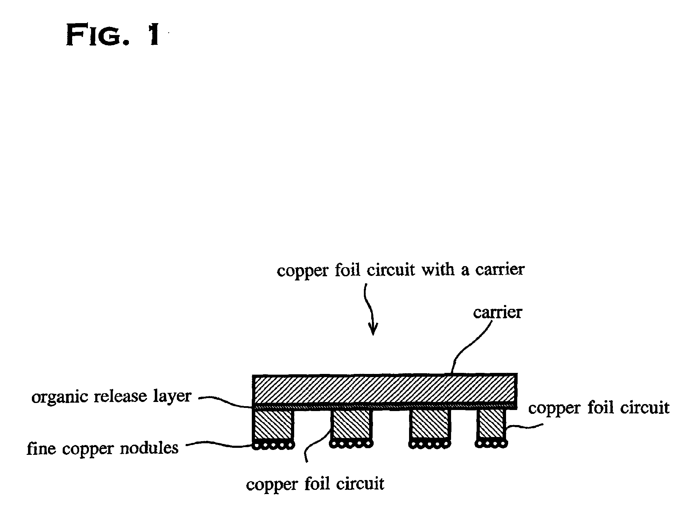

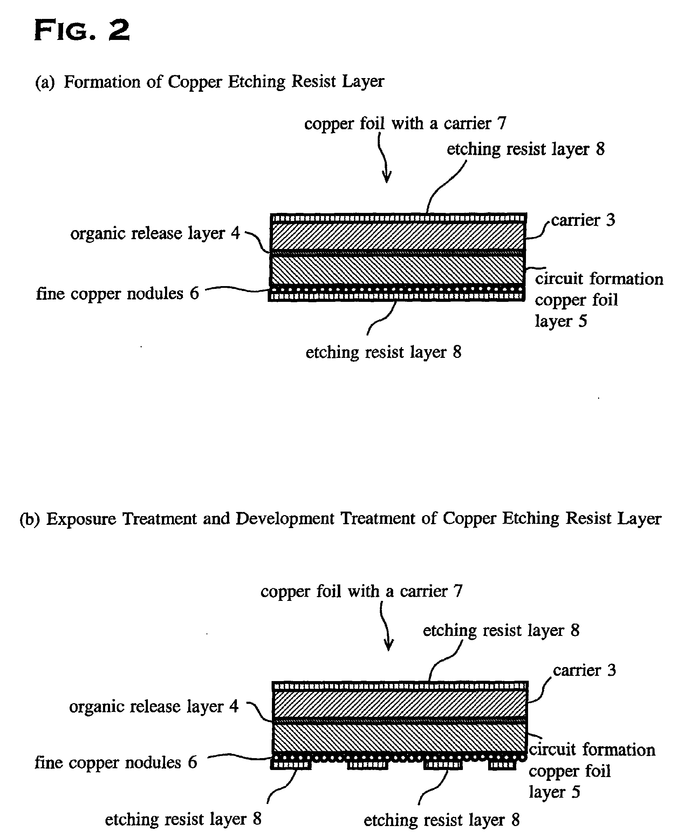

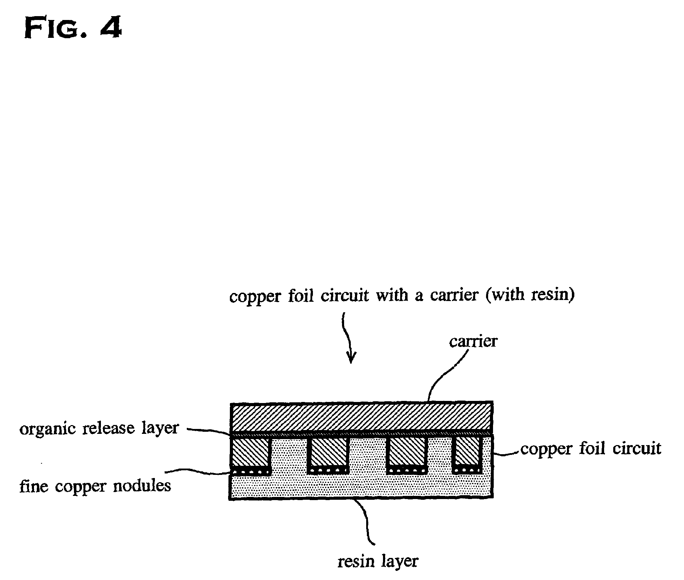

Fig. 1 is a schematic view showing a cross section of a copper foil circuit with a carrier. Fig. 2 and Fig. 3, Fig. 5 to Fig. 8 are conceptual figures which are used to show a flow chart for manufacturing a printed wiring board. Fig. 4 illustrates a cross sectional schematic view showing a copper foil circuit with a carrier.

### SUMMARY OF THE INVENTION

In view of the above, the inventors of the present invention, as a result of hard and diligent researches, have thought of and accomplished the present invention which is capable of greatly reducing the production cost for manufacturing a printed wiring board, thereby making it possible to supply an improved printed wiring board at a reduced cost. In the following, the present invention will be described in more detail.

An invention recited in claim 1 is a copper foil circuit with a carrier having a copper foil circuit layer formed on one or each of both surfaces of a carrier, characterized in that: an organic release layer is interposed between the carrier and each copper foil circuit layer. Fig. 1 is a schematic sectional view showing the copper foil circuit with a carrier. As may be clearly understood with reference to Fig. 1, an organic release layer is interposed between the carrier and a copper foil circuit layer, so that the copper layer which has already been formed into a desired circuit, presents configuration in which the copper foil circuit has been attached to the carrier.

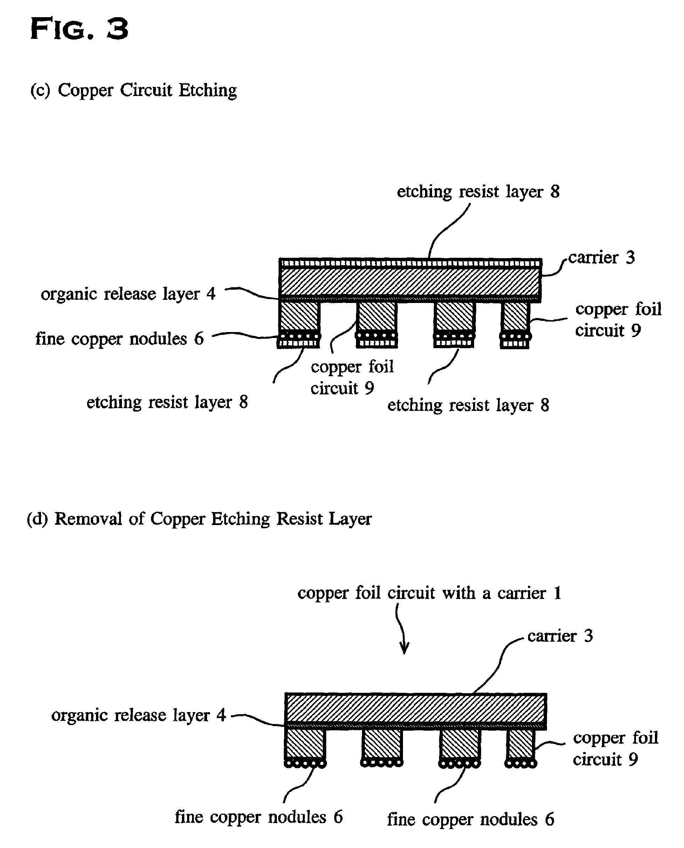

The copper foil circuit with a carrier shown in Fig. 1 is manufactured by using a copper foil with a carrier having an organic release layer formed on the carrier, and having a circuit formation copper foil layer formed on the organic release layer. Namely, as shown in Fig. 2(a), the copper foil with a carrier has a carrier surface and a rough surface formed by attaching thereto an amount of fine copper particles. Each of the two surfaces has an etching resist layer formed thereon. Then, as shown in Fig. 2(b), an exposure treatment and a development treatment are carried out to form a desired pattern constituting the copper foil circuit. Subsequently, a copper etching treatment is performed so that the material becomes into a state shown in Fig. 3(c). Afterwards, the etching resist layers are removed, thereby obtaining the copper foil circuit with a carrier shown in Fig. 1.

Therefore, the organic release layer shown in Fig. 1 is formed not only between the copper foil circuit layer portions and the carrier, but also coverring the entire one surface of the carrier. Such kind of an organic release layer is provided in order to effect an easy separation of the carrier from the copper foil circuit when at a later time the carrier is to be torn away from the copper foil circuit. In this way, the organic release layer is required to be present at least between the carrier and the copper foil circuit.

For use as an organic agent to form the organic release layer, it is preferable to utilize one, two or more kinds of substances selected from nitrogen-containing organic compounds, sulphur-containing organic compounds and carboxylic acids.

Among nitrogen-containing organic compounds, sulphur-containing organic compounds and carboxylic acids, the nitrogen-containing organic compounds contain substituent groups. In detail, for use as a nitrogen-containing organic compound, it is preferable to use 1, 2, 3-benzotriazole (hereinafter referred to as "BTA") which is a triazole compound having substituent groups, carboxy benzotriazole (hereinafter referred to as "CBTA"), N',N'-bis(benzotriazoryl methyl) urea (hereinafter referred to as "BTD-U"), 1H-1, 2, 4-triazole (hereinafter referred to as "TA") and 3-amino-1H-1,2,4-triazole (hereinafter referred to as "ATA").

For use as a sulphur-containing organic compound, it is preferable to use mercapto benzothiazole (hereinafter referred to as "MBT"), thiocyanuric acid (hereinafter referred to as "TCA"), and 2-benzimidazole thiol (hereinafter referred to as "BIT").

For use as a carboxylic acid, it is preferable to use a monocarboxylic acid, more preferably, oleic acid, linoleic acid and linolenic acid.

As a method for forming the organic release layer, it is possible to dissolve the above-mentioned organic agent in a solvent so as to form a solution, followed by dipping a carrier into the solution. Alternatively, it is also possible to use one of other methods including showerring, spraying, dripping and electrocoating to treat the carrier's one surface on which the release layer is to be formed. In fact, it is not necessary to use any particularly specified method. At this time, the concentration of one or more organic agents in a solvent is preferred to be 0.01 g/l to 10 g/l, its liquid temperature is preferred to be in a range of 20 to 60°C. In practice, the concentration of one or more organic agents in a solvent does not have to be limited to any extent, but is allowed to be high or low and this will not cause any problems.

Furthermore, the formation of the release layer using an organic agent may be made possible through proper combination of the above-described organic agents, and it is also possible that the above-discussed formation method may be carried out repeatedly. In this way, it becomes possible to control the thickness of the release layer with a further higher precision.

As a result of taking into account the above-mentioned facts, it has been found that if the concentration of an organic agent is lower than the above lower limit of 0.01 g/l, it will be difficult for the organic agent to adhere to the surface of the carrier within a short time, and it will thus be difficult for the release layer to have a uniform thickness. Consequently, it is impossible to stabilize the product quality. On the other hand, if the concentration of an organic agent is higher than the above higher limit of 10 g/l, the speed for the organic agent to adhere to the surface of the carrier will not become higher only by increasing the concentration of the organic agent, nor will such a concentration be recommendable in view of manufacturing cost.

By using the above-described organic agents, it is possible to easily control an amount of any agent when forming the release layer, so as to make a combining strength between the carrier and the copper foil circuit in a range of 1 to 300 gf/cm. Furthermore, it has become possible to obtain an excellent thermal stability and to ensure a stabilized stripping strength after the materials have been pressed into a copper clad laminate. Therefore, the carrier can be easily stripped and removed from the copper foil circuit layer.

Furthermore, claim 2 recites, as shown in Fig. 4 serving as a cross sectional schematic view, a copper foil circuit with a carrier characterized in that a resin layer is formed on the outer surface of the copper foil circuit layer of the copper foil circuit with a carrier. This copper foil may be obtained by at first forming the copper foil circuit with a carrier shown in Fig. 1, and then forming a resin layer on the rough surface side of the copper foil circuit layer. By virtue of the presence of the resin layer, it is not necessary to use a prepreg when the copper foil circuit layer is used as an external copper foil, and it is possible to eliminate an undulation possibly caused due to a glass cross weave often occurring on the surface of the copper clad laminate after hot pressing, thereby rendering it easy to form fine pattern circuit.

The resin layer is formed by using 60 to 90 wt% of an epoxy resin (containing 0.5 to 40 wt% of a rubber modified epoxy resin), 5 to 10 wt% of a polyvinyl acetal, 0.1 to 20 wt% of a urethane resin, with the mixture of these resins being applied to the surface on which the copper foil circuit has been formed, followed by being heated and dried to be a semi-cured B-stage. The resin layer having the above composition, during the hot pressing of the copper clad laminate, can be fully cured along with the prepreg resin, thereby forming an insulating layer for the copper clad laminate.

Next, a method for manufacturing a printed wiring board, which is recited in claim 3, is described. Namely, claim 3 recites a method for manufacturing a printed wiring board by using the copper foil circuit with a carriers recited in claim 1 or 2, the method comprising: using the copper foil circuit with a carriers and at least one prepreg each forming a resin base material, carrying out a hot pressing under a condition in which each surface with a copper foil circuit formed thereon has been brought into contact with the at least one prepreg, thereby producing a copper clad laminate; stripping and thus removing the carriers from the outer surfaces of the outer layers of the copper clad laminate so as to produce the printed wiring board. This method, by using the copper foil circuit with a carrier recited in claim 1 or 2, is a first applicable method for manufacturing a printed wiring board.

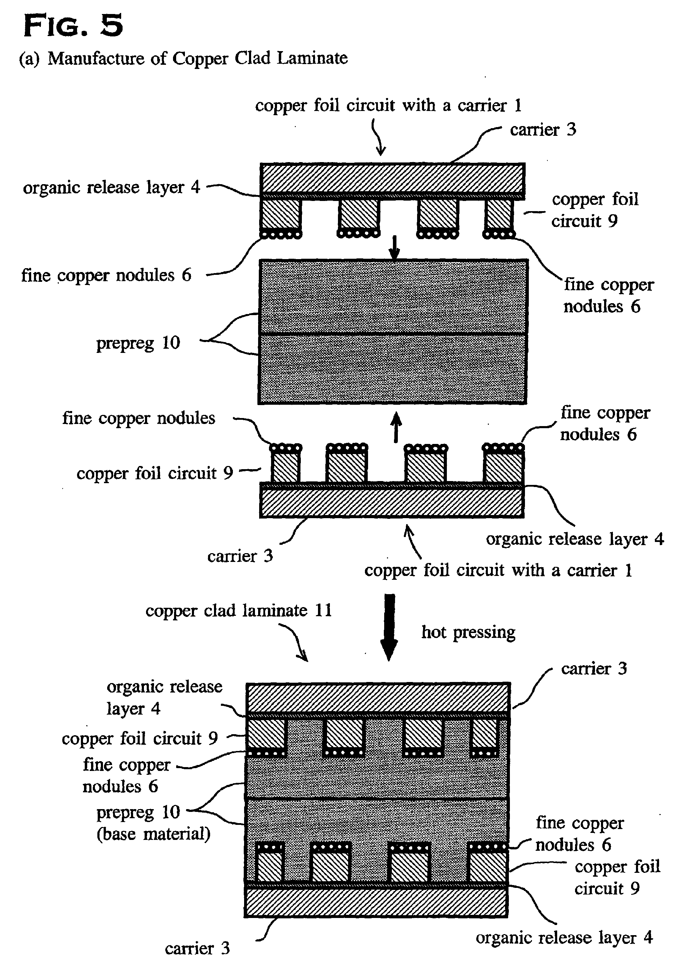

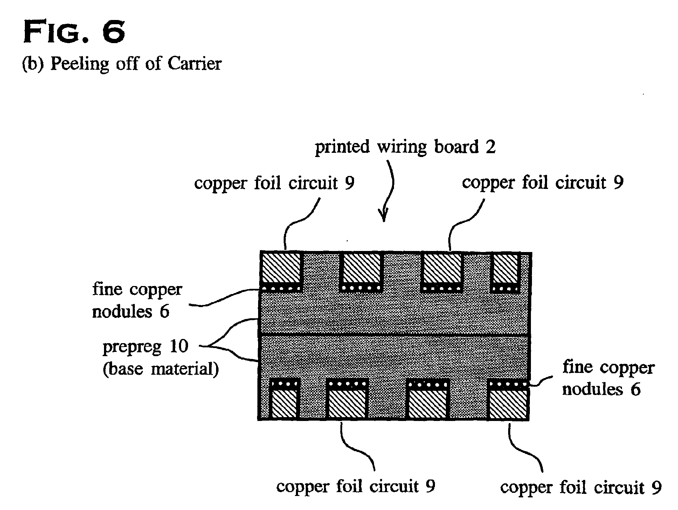

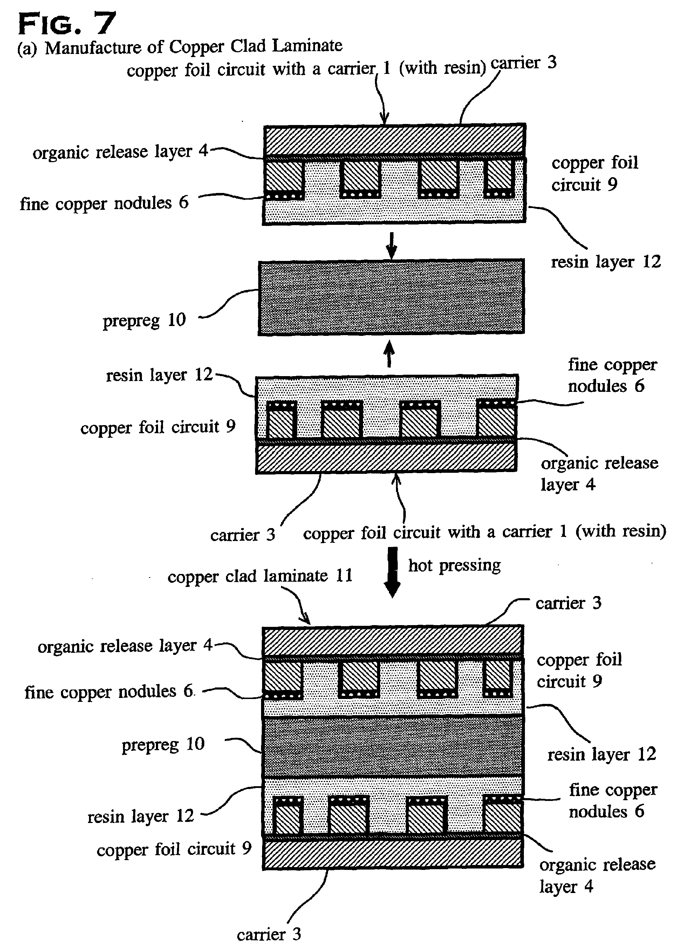

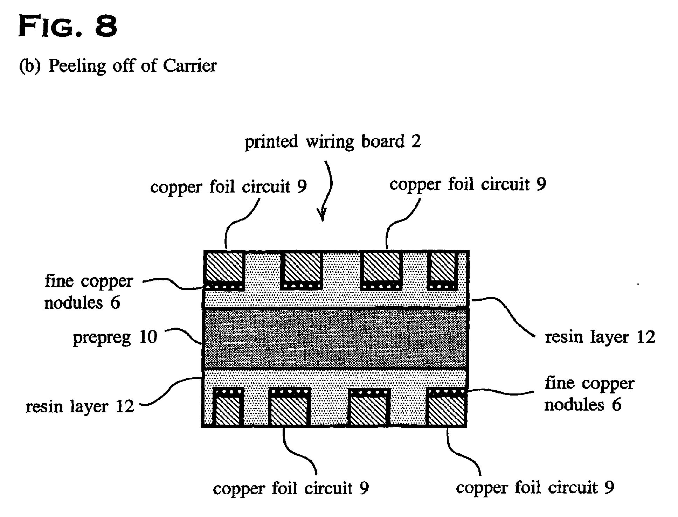

The copper foils recited in both claim 1 and claim 2 can be manufactured in the following way. Namely, since an already formed copper foil circuit is supported by the carrier, a hot pressing may be carried out under a condition in which a surface with the copper foil circuit formed thereon has been brought into contact with the prepreg, thereby producing a copper clad laminate. What have been used to schematically show such an arrangement are Fig. 5(a) and Fig. 7(a). Then, at a next step, by tearing off the copper clad laminate's carriers formed in the steps shown in Fig. 5(a) and Fig. 7(a), it is possible to obtain the printed wiring board in which the copper foil circuit are buried in the base material resin, as shown in Fig. 6(b) and Fig. 8(b), and recited in claim 4. Since the copper foil circuit is formed in the above manner, i.e., not projecting from the surface of the copper clad laminate like a common printed wiring board, it is possible to prevent a wire breakage which would otherwise be caused when the circuit is get caught by some other things during the handling of the printed wiring board.

The method of manufacturing the printed wiring board is characterized in that it is possible to shorten the production process, particularly to dispense with all the main steps usually involved in a conventional process for manufacturing a printed wiring board. Therefore, a large scale equipment investment is not required, and a process for manufacturing a printed wiring board can be greatly simplified and shortened.

### EMBODIMENTS FOR CARRYING OUT THE INVENTION

In the following, the present invention is described in more detail by giving embodiments showing how to use the copper foil circuit with a carrier 1 of the present invention to manufacture the printed wiring board 2.

### First Embodiment

This embodiment will be described with reference to Fig. 2, Fig. 3, Fig. 5 and Fig. 6. The copper foil circuit with a carrier 1 used in the present embodiment was manufactured by using a copper foil with a carrier. Namely, an electrolytic copper foil having a nominal thickness of 18 µm was used as a carrier 3. Then, a so-called copper foil surface treatment machine as well as an organic agent called carboxy benzotriazole were used to form an organic release layer 4 on the shiny side of the carrier 3. Subsequently, a circuit formation copper foil layer 5 having a thickness of 5 µm was formed on the organic release layer 4, thereby producing a copper foil with a carrier 7 which was then used to manufacture the copper foil circuit with a carrier 1. At this time, an amount of fine copper particles 6 are caused to adhere to the circuit formation copper foil layer 5. Afterwards, both surfaces of the copper foil with a carrier 7 were coated with zinc to obtain a rust preventing effect. However, in the accompanying drawings attached to the present specification, the rust preventive layers are not shown.

By laminating a dry film onto each surface of the copper foil with a carrier 7, two copper etching resist layers 8 can thus be formed in a manner shown in Fig. 2(a). In fact, a commercially available dry film manufactured by Nichigo Alpho Co., Ltd. was used to form the copper etching resist layers 8. Afterward, as shown in Fig. 2(b), an exposure treatment was carried out to treat one copper etching resist layer 8 to develop a circuit pattern for forming a copper foil circuit. At this time, as shown in Fig. 2(a) and Fig. 2(b), the entire surface of the carrier 3 is formed with the copper etching resist layers 8 using the same dry film.

Subsequently, a cupric chloride etching solutoin was used to carry out an etching treatment on the circuit formation copper foil layer 5, with the etching treatment starting from the copper foil's one side to which the fine copper particles 6 have been attached, thereby forming a copper foil circuit 9, as shown in Fig. 3 (c). After forming the copper foil 9, a commercially available dry film removal solution was used to wet-remove the hardened dry film, thereby obtaining the desired copper foil circuit with a carrier 1, as shown in Fig. 3(d).

The copper foil circuits with a carrier 1 and prepregs 10 forming a resin base material were brought together and subjected to a hot pressing, thereby producing a copper clad laminate 11. At this time, each copper foil circuit with a carrier's one surface on which a copper foil circuit 9 has been formed was orientated in a manner such that it can be brought into contact with a prepreg 10, so that these materials were laminated one upon another and pressed together in a manner shown in Fig. 5(a). At this moment, as shown in Fig. 5(a), two prepregs 10 were used, with one piece of copper foil circuit with a carrier 1 being disposed on the outer surface of each prepreg, thereby forming a double-sided circuit board structure.

After the copper clad laminate 10 had been manufactured, the carriers 3 positioned on the outer surfaces of the outer layers of the copper clad laminate 11 were stripped off so as to be removed therefrom, thereby making it possible to manufacture a printed wiring board shown in Fig. 6(b).

### Second Embodiment

Here, the copper foil circuit with a carrier 1 used in the first embodiment was replaced by an equivalent which is equal to the copper foil circuit with a carrier 1 but includes a resin layer 12 recited in claim 2, thereby producing another desired copper clad laminate. Since the conditions for carrying out the present embodiment were the same as those of the above first embodiment, the same and repeated descriptions will be omitted, but the description of different portions will not. However, even with regard to the copper foil circuit with a carrier having the resin layer 12, the reference numeral 1 will still be used to represent the same item as in the case where the resin layer is not used.

The resin layer 12 formed in the copper foil circuit with a carrier 1, as shown in Fig. 7(a), is located on the circuit side of the copper foil circuit with a carrier 1, forming a resin layer having a thickness of 10 µm extending away from the carrier 3. Then, the resin layer was dried and cured to the state of stage B. Here, the above resin contains 60 wt% of bisphenol A type epoxy resin (trade name: EPOMIC R-301, manufactured by Mitsui Petroleum Chemistry Co., Ltd.), 20 wt% of rubber modified epoxy resin (trade name: EPOTOHTOYR - 102, manufactured by Toto Chemical Co., Ltd.) corresponding to 25 wt% of the total amount of the epoxy resin, 10 wt% of polyvinyl acetal resin (trade name: DENKABUTYRAL 5000A, manufactured by Electrochemistry Industry Co., Ltd.), 10 wt% of urethane resin (trade name: KORONATE AP-Stable, manufactured by Nippon Polyurethane Co., Ltd.), 2 wt% of dicyanoamide (reagent) for use as a curing agent for hardening the epoxy resin, which is in the form of dimethyl formaldehyde liquid having 25% solid components, 0.5 wt% of solidification promoting agent (trade name: CAZOL 2E4MZ, manufactured by Shikoku Chemistry Co., Ltd.), all of the above substances being dissolved in an amount of methylethyl ketone, thereby forming a resin composition having 45% solid components.

The above obtained resin composition was applied to each copper foil circuit with a carrier 1's one surface on which the copper foil circuit 9 has been formed, followed by a drying treatment and further by a heating treatment performed at a temperature of 150°C for 7 minutes, thereby obtaining a semi-cured resin layer 12 having a thickness of 100 µm. Here, the thickness of the resin layer 12 means a thickness measured from the organic release layer 4 of each carrier 3.

Copper foil circuit with a carrier 1 and a prepreg 10 forming a resin base material were brought together and subjected to a hot pressing, thereby producing a copper clad laminate 11. At this time, each copper foil circuit with a carrier 1's one surface on which the copper foil circuit 9 has been formed was orientated in a manner such that it can be brought into contact with the prepreg 10, so that they were laminated one upon another and pressed together in a manner shown in Fig. 7(a). At this moment, as shown in Fig. 7(a), one sheet of prepreg 10 was used, with one piece of copper foil circuit with a carrier 1 being disposed on either outer surface of the prepreg, thereby forming a double-sided circuit board structure.

After the copper clad laminate 10 had been manufactured in the same manner as in the first embodiment, the carriers 3 positioned on the outer surfaces of the outer layers of the copper clad laminate 11 were peeled off and removed therefrom, thereby enabling manufacture of a printed wiring board 2 shown in Fig. 8(b).

### Effect of the Invention

The copper foil circuit with a carrier formed according to the present invention enables adoption of an improved process for manufacturing printed wiring board, which was not existing and simpler than that used in prior art. Therefore, if viewed in total, it is possible to greatly reduce the cost for manufacturing a printed wiring board, thus making it sure to supply an improved printed wiring board having a high quality at a low price.

## Claims

1. A copper foil circuit with a carrier, having a copper foil circuit layer formed on one or both surfaces of a carrier, wherein
an organic release layer is interposed between the carrier and copper foil circuit layer.

2. A copper foil circuit with a carrier, wherein a resin layer is formed on an outer surface of the copper foil circuit layer of the copper foil circuit with a carrier of claim 1.

3. A method for manufacturing a printed wiring board by using the copper foil circuit with a carrier of claim 1, wherein said method comprises the steps of:
using the copper foil circuit with a carrier and at least one prepreg each forming a resin base material, carrying out a hot pressing under a condition in which each surface with a copper foil circuit formed thereon has been brought into contact with the at least one prepreg, thereby producing a copper clad laminate; and
peeling and thus removing the carriers from the outer surfaces of the outer layers of the copper clad laminate so as to produce the printed wiring board.

4. A printed wiring board, wherein the copper foil circuit obtained in the printed wiring board manufacturing method of claim 3 are buried into and thus disposed in the base material.
